# DEMANDE DE BREVET EUROPEEN

(11) **EP 4 407 825 A1**
(43) Date de publication de la demande: **31.07.2024**
(21) Numéro de dépôt: 24150146.9
(22) Date de dépôt: 03.01.2024
(51) Int. Cl.: H02H 3/087, H02H 3/18

(54) **DISPOSITIF ÉLECTRONIQUE DE PROTECTION D'UNE CHARGE ÉLECTRIQUE, SYSTÈME D'ALIMENTATION D'UNE CHARGE ÉLECTRIQUE ET PROCÉDÉ DE COMMANDE D'UN TEL DISPOSITIF**

(30) Priorité: 04.01.2023 FR 2300079
(71) Demandeur: SCHNEIDER ELECTRIC INDUSTRIES SAS, 92500 Rueil-Malmaison (FR)
(72) Inventeur: CHAMBON, Patrick, 38400 SAINT MARTIN D'HERES (FR)
(74) Mandataire: Lavoix

(57) **Abrégé**

Ce dispositif électronique (10) de protection d'une charge comprend :
- un arrangement de transistor(s) (20) en série avec la charge, commandable dans un état parmi des états passant (A) et bloqué (B, C) l'état bloqué étant parmi des premier (B) et deuxième (C) états bloqués ;
- un capteur de courant (24) ;
- un module de commande (26) connecté au capteur de courant et commandant l'arrangement de transistor(s) dans son deuxième état bloqué si une intensité (I), mesurée par le capteur de courant, est supérieure à un premier seuil (I₁) ; et
- un capteur de tension (25) connecté au module de commande ;
le module de commande commandant l'arrangement de transistor(s) (20) dans son état passant (A) si la tension (V) est supérieure à un seuil de tension (Vₜₕ) et dans son premier état bloqué (B) si l'intensité (I) est inférieure à un deuxième seuil (I₂).

## Description

La présente invention concerne un dispositif électronique de protection d'une charge électrique, un système d'alimentation d'une charge électrique et un procédé de commande d'un tel dispositif de protection.

Pour protéger les appareils électriques des surintensités qui peuvent avoir lieu dans un circuit électrique, il est connu d'utiliser des dispositifs qui permettent d'interrompre la circulation du courant électrique, notamment des disjoncteurs. Une implémentation spécifique des disjoncteurs, mettant en oeuvre des transistors, est déjà connue ; et de tels disjoncteurs réalisés à base de transistors sont également appelés SSCB (de l'anglais *Solid State Circuit Breakers).*

Cependant, les SSCB ne protègent pas les appareils branchés au circuit électrique contre d'autres phénomènes pouvant endommager les appareils.

Le but de la présente invention est de remédier à l'inconvénient précité, en proposant un dispositif électronique de protection, qui, en plus de protéger les appareils branchés au circuit électrique contre des surintensités, les protège contre des inversions de polarité, le dispositif de protection visant également à fournir une protection contre des retours de courant vidant dans le circuit électrique l'énergie stockée dans les appareils, tout en limitant les pertes par rapport aux disjoncteurs existants.

A cet effet, l'invention a pour objet un dispositif électronique de protection d'une charge électrique contre une surintensité d'un courant électrique, le dispositif de protection comprenant :
- un arrangement d'au moins un transistor propre à être connecté en série avec la charge, l'arrangement d'au moins un transistor comportant deux pôles de conduction et un pôle de commande et étant commandable, via son pôle de commande, dans un état parmi un état passant dans lequel le courant circule entre les pôles de conduction, et un état bloqué dans lequel le courant ne circule pas entre les pôles de conduction, l'état bloqué étant parmi un premier état bloqué et un deuxième état bloqué ;
- un capteur de courant configuré pour mesurer une intensité du courant destiné à circuler à travers la charge ;
- un module de commande connecté au capteur de courant et configuré pour commander l'arrangement d'au moins un transistor via son pôle de commande, le module de commande étant configuré pour commander l'arrangement d'au moins un transistor dans son deuxième état bloqué si l'intensité du courant, mesurée par le capteur de courant, est supérieure à un premier seuil d'intensité ;
- un capteur de tension connecté au module de commande et configuré pour mesurer une tension entre les pôles de conduction de l'arrangement d'au moins un transistor ; et
le module de commande étant configuré en outre pour commander l'arrangement d'au moins un transistor dans son état passant depuis son premier état bloqué si la tension entre les pôles de conduction, mesurée par le capteur de tension, est supérieure à un seuil de tension ; et dans son premier état bloqué si l'intensité du courant, mesurée par le capteur de courant, est inférieure à un deuxième seuil d'intensité, distinct du premier seuil d'intensité.

Une idée à la base de l'invention est d'implémenter une diode dans un SSCB. La diode est alors une diode « virtuelle », par opposition aux diodes réelles réalisées sous forme d'un composant dédié, telles les diodes au silicium. La diode virtuelle est implémentée via le ou les transistors du SSCB, et est pilotée par le module de commande du SSCB. Ainsi, il n'est plus nécessaire d'ajouter une diode connectée à la charge, en plus d'un disjoncteur, l'invention permettant d'obtenir les deux fonctions, disjoncteur et diode, dans un même dispositif. De plus, l'implémentation de la diode virtuelle permet de diminuer les pertes dans le système électrique par rapport à une diode réelle.

Suivant d'autres aspects avantageux de l'invention, le dispositif comprend une ou plusieurs des caractéristiques suivantes, prises isolément ou suivant toute combinaison techniquement possible :
- l'arrangement d'au moins un transistor est configuré pour revenir dans l'état passant depuis le deuxième état bloqué seulement suite à un réarmement d'un utilisateur, et le module de commande est configuré pour maintenir l'arrangement d'au moins un transistor dans le deuxième état bloqué en l'absence du réarmement de la part de l'utilisateur ;
- l'arrangement d'au moins un transistor comprend plusieurs transistors connectés en série et/ou en parallèle ;
- le dispositif électronique de protection comprend en outre un module de dissipation d'énergie connecté en parallèle de l'arrangement d'au moins un transistor, le module de dissipation étant configuré pour dissiper une énergie magnétique associée au courant électrique, lors de la commutation de l'arrangement d'au moins un transistor dans son état bloqué ; et
- le deuxième seuil d'intensité est inférieur au premier seuil d'intensité.

La présente invention a également pour objet un système d'alimentation d'une charge électrique, comprenant une pluralité de dispositifs de conversion d'énergie électrique, chaque dispositif de conversion étant propre à être connecté à une source d'énergie électrique correspondante, chaque dispositif de conversion étant configuré pour convertir une première énergie électrique reçue en entrée depuis la source respective en une deuxième énergie électrique délivrée en sortie,
- une pluralité de dispositifs électroniques de protection, chaque dispositif de protection étant connecté en sortie d'un dispositif de conversion respectif et propre à être connecté à la charge électrique pour lui fournir la deuxième énergie électrique délivrée par le dispositif de conversion respectif, chaque dispositif de protection étant tel que défini ci-dessus.

Suivant d'autres aspects avantageux de l'invention, le système comprend une ou plusieurs des caractéristiques suivantes, prises isolément ou suivant toute combinaison techniquement possible :
- au moins un dispositif de conversion est un dispositif de conversion d'énergie électrique alternative en énergie électrique continue ; et
- au moins un dispositif de conversion est un dispositif de conversion d'énergie électrique continue en énergie électrique continue.

La présente invention a également pour objet un procédé de commande d'un dispositif électronique de protection d'une charge électrique contre une surintensité d'un courant électrique, le dispositif de protection étant tel que défini ci-dessus, le procédé comportant :
- une première étape de mesure, par le capteur de courant, de l'intensité du courant circulant à travers la charge ;
- une étape de commande, par le module de commande, de l'arrangement d'au moins un transistor dans son deuxième état bloqué si l'intensité du courant, mesurée lors de la première étape de mesure, est supérieure à un premier seuil d'intensité ;
- une deuxième étape de mesure, par le capteur de tension, de la tension entre les pôles de conduction de l'arrangement d'au moins un transistor ; et
lors de l'étape de commande, l'arrangement d'au moins un transistor est commandé dans son état passant depuis son premier état bloqué par le module de commande, si la tension entre les pôles de conduction, mesurée lors de la deuxième étape de mesure, est supérieure à un seuil de tension ; et lors d'une étape de commande, l'arrangement d'au moins un transistor est commandé dans son premier état bloqué par le module de commande, si l'intensité du courant, mesurée lors de la première étape de mesure, est inférieure à un deuxième seuil d'intensité, distinct du premier seuil d'intensité.

Suivant un autre aspect avantageux de l'invention, le procédé de commande comprend la caractéristique suivante :
- les valeurs du seuil de tension, du premier seuil d'intensité et du deuxième seuil d'intensité sont modifiables par un utilisateur, lors de l'utilisation du dispositif électronique de protection.

L'invention sera mieux comprise à la lecture de la description qui va suivre, donnée uniquement à titre d'exemple non limitatif et faite en se référant aux dessins sur lesquels :
[Fig 1] la figure 1 est une vue schématique d'un système redondant d'alimentation électrique d'une charge électrique, le système comprenant trois dispositifs électroniques de protection, conformes à l'invention ;
[Fig 2] la figure 2 est une représentation schématique d'un des dispositifs électroniques de protection de la figure 1, conformes à l'invention, et d'une machine d'états associée au fonctionnement du dispositif de protection ; et
[Fig 3] la figure 3 est un organigramme d'un procédé de commande du dispositif électronique de protection, conforme à l'invention.

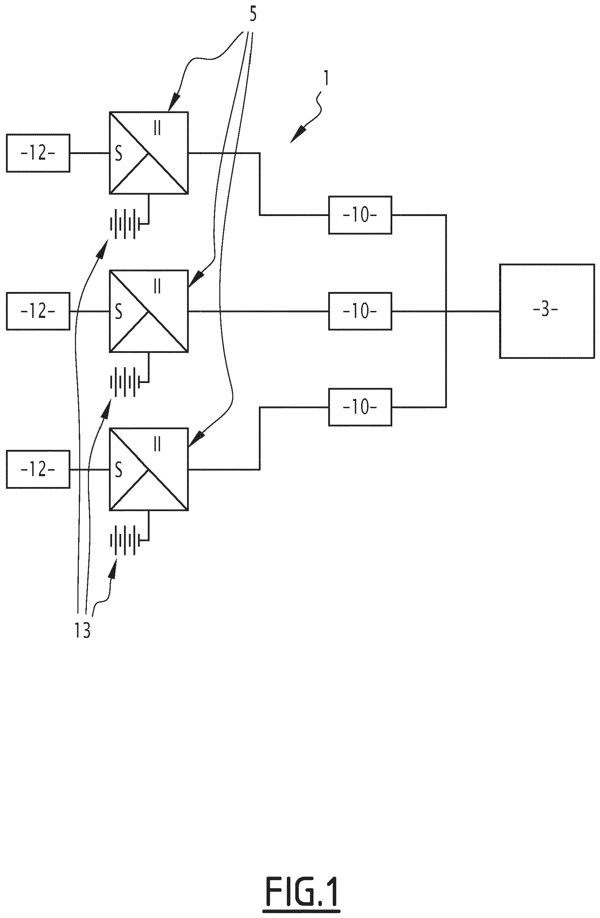

Sur la figure 1, un système 1 d'alimentation d'une charge électrique 3 comprend plusieurs convertisseurs d'énergie électrique 5 et plusieurs dispositifs électroniques de protection 10. Dans l'exemple de la figure 1, le système d'alimentation 1 comprend trois convertisseurs d'énergie électrique 5 et trois dispositifs de protection 10.

Chaque convertisseur 5 est propre à être connecté à une source d'énergie électrique respective 12. Ces sources 12 sont par exemple des sources de courant alternatif externes. Le courant alternatif provient, par exemple de générateurs de courant alternatifs ou de réseaux électriques, auxquels sont connectés les convertisseurs 5. Sur la figure 1, les sources d'énergie 12 sont séparées.

Selon une variante non représentée, chaque convertisseur 5 est relié à une seule et même source d'énergie électrique 12.

Alternativement, ou en complément, chaque convertisseur 5 est avantageusement propre à être connecté à une source de courant continu 13. Ces sources de courant continu 13 sont par exemple des batteries. Chaque convertisseur 5 est relié à une source de courant continu 13 respective, ainsi que montré sur la figure 1, et le système d'alimentation 1 est alors relié à plusieurs sources de courant continu 13. En variante non représentée, chaque convertisseur 5 est relié à une seule et même source de courant continu 13, et le système d'alimentation 1 est alors relié à une unique source de courant continu 13.

Chaque convertisseur 5 est configuré pour convertir un courant alternatif en courant continu, et/ou un courant continu en courant continu selon qu'il est connecté à une source d'énergie 12 alternative respective et/ou à une source de courant continu 13 respective. Un premier convertisseur 5 est par exemple configuré pour convertir du courant continu en courant continu, pendant que les deux autres convertisseurs 5 sont configurés pour convertir du courant alternatif en courant continu, toutes les combinaisons étant possibles.

Chaque convertisseur 5 est connecté en sortie à un dispositif électronique de protection 10.

En variante non représentée, chaque dispositif de protection 10 est directement relié à une source d'énergie 13 continue respective, sans convertisseur entre le dispositif de protection 10 et la source d'énergie 13.

Chaque dispositif électronique de protection 10 est typiquement connecté en sortie à une charge 3, de telle sorte que la charge 3 est alimentée par les convertisseurs 5, qui lui fournissent le courant continu. La charge 3 est tout appareil nécessitant d'être alimenté par du courant continu, par exemple une batterie, un appareil électronique comme un ordinateur portable ou un serveur. Ainsi, dans l'exemple de la figure 1, trois circuits électriques distincts alimentent la charge 3. En cas de surintensité dans l'un des circuits électriques, le dispositif de protection 10 correspondant est propre à couper la circulation du courant dans le circuit électrique en surintensité.

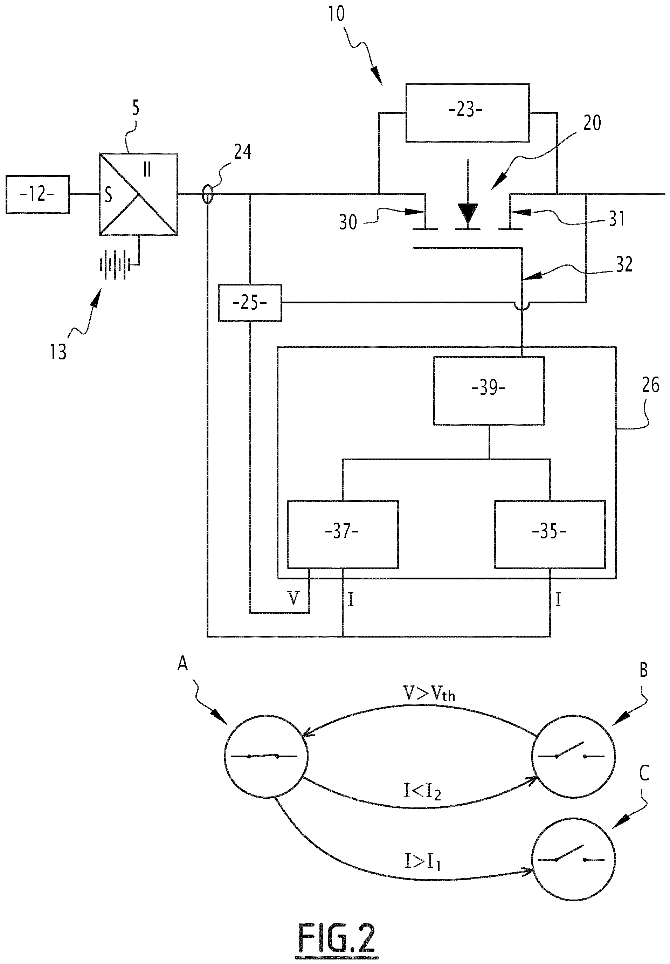

Sur la partie supérieure de la figure 2 est représenté le dispositif électronique de protection 10 comprenant un arrangement d'au moins un transistor 20, un module de dissipation d'énergie 23 un capteur de courant 24, un capteur de tension 25 et un module de commande 26.

Le dispositif électronique de protection 10 est connecté en sortie du convertisseur 5, et la sortie du dispositif de protection 10 est connectée à la charge 3. En particulier, l'arrangement d'au moins un transistor 20 est connecté en sortie du convertisseur 5, et la sortie de l'arrangement d'au moins un transistor 20 est connectée à la charge 3.

L'arrangement d'au moins un transistor 20 comprend deux pôles de conduction 30 et 31, aussi appelés bornes de conduction 30 et 31, et un pôle de commande 32, aussi appelé borne de commande 32. Chaque transistor de l'arrangement d'au moins un transistor 20 est par exemple réalisé en silicium, ou encore en nitrure de gallium ou carbure de silicium.

L'arrangement d'au moins un transistor 20 est commandable, via son pôle de commande 32, dans un état parmi un état passant A dans lequel le courant circule entre les pôles de conduction 30, 31, et au moins un état bloqué B ou C dans lequel le courant ne circule pas entre les pôles de conduction 30, 31. Ces états passant A et bloqué B, C sont décrits plus en détail par la suite.

L'arrangement d'au moins un transistor 20 est configuré pour couper le courant de manière bidirectionnelle dans l'au moins un état bloqué B, C, c'est-à-dire quel que soit le sens de circulation du courant, de la source 12 vers la charge.3, ou bien de la charge 3 vers la source 12.

L'arrangement d'au moins un transistor 20 est par exemple constitué d'un unique transistor avec une capacité de coupure de courant bidirectionnelle, ainsi que représenté sur la figure 2.

En variante, l'arrangement d'au moins un transistor 20 est un assemblage de transistors connectés en parallèle et/ou en série. Selon cette variante, l'arrangement d'au moins un transistor 20 est alors un assemblage de transistors connectés en série ; ou un assemblage de transistors connectés en parallèle ; ou encore un assemblage de transistors connectés en série et en parallèle, l'assemblage comprenant alors plusieurs branches de transistors montées en parallèle, avec au moins une branche comportant plusieurs transistors connectés en série, et de préférence chaque branche comportant plusieurs transistors connectés en série.

Selon cette variante, les transistors en parallèle sont présents pour conduire suffisamment de courant, et limiter les pertes. Certaines technologies de transistor ne sont capables d'interrompre le courant que dans un sens, aussi les transistors en série sont avantageusement connectés tête-bêche pour permettre une coupure de courant bidirectionnelle.

L'arrangement d'au moins un transistor 20 comprend par exemple des transistors à effet de champ à grille isolée, également appelés MOSFET (de l'anglais *Metal Oxide Semiconductor Field Effect Transistor*) ; des transistors à effet de champ (sans grille isolée), également appelés FET (de l'anglais *Field Effect Transistor*), ou des transistors bipolaires à grille isolée, également appelés IGBT (de l'anglais *Insulated Gate Bipolar Transistor*) ; ou encore une combinaison de ces différents transistors. Plus généralement, l'arrangement d'au moins un transistor 20 comprend au moins un composant semi-conducteur commandable de commutation.

Le module de dissipation d'énergie 23 est connecté en parallèle de l'arrangement d'au moins un transistor 20, c'est-à-dire entre les pôles de conduction 30 et 31. Le module de dissipation d'énergie 23 permet de dissiper l'énergie magnétique stockée dans un circuit, par exemple dans des câbles du circuit, lors de l'ouverture du circuit. Le module de dissipation d'énergie 23 est par exemple une diode transil, configurée pour écrêter les surtensions lors de l'ouverture du circuit, ou une varistance.

Le capteur de courant 24 est connecté au module de commande 26. Il est configuré pour mesurer l'intensité du courant destiné à circuler dans la charge 3, en mesurant l'intensité du courant par exemple en entrée du dispositif de protection 10. Le capteur de courant 24 consiste par exemple en un tore de Rogowski, en un élément semi-conducteur placé dans un circuit magnétique, ou encore en une résistance de shunt, dont on mesure la tension afin d'en déduire l'intensité du courant qui la traverse.

Le capteur de tension 25 est connecté aux pôles de conduction 30 et 31 de l'arrangement d'au moins un transistor 20 d'une part et au module de commande 26 d'autre part. Il est configuré pour mesurer la tension aux bornes des pôles de conduction 30 et 31. Le capteur de tension 25 consiste par exemple en un dispositif diviseur de tension utilisant des résistances électriques.

Le module de commande 26 est configuré pour commander le pôle de commande 32 de l'arrangement d'au moins un transistor 20. Le module de commande 26 est adapté pour remplir une fonction de disjoncteur statique, symbolisée par la fonction disjoncteur statique 35, et en outre - selon l'invention, une fonction de diode, symbolisée par la fonction diode 37, en fonction des mesures d'intensités et de tension fournies par le capteur de courant 24 et le capteur de tension 25. Le module de commande 26 est alors configuré pour recevoir une valeur d'intensité I du courant destiné à circuler à travers la charge 3, mesurée par le capteur de courant 24, puis pour comparer la valeur d'intensité I reçue à un premier seuil d'intensité I₁ et à un deuxième seuil d'intensité I₂. Le module de commande 26 est alors configuré pour recevoir également une valeur de tension V, mesurée entre les pôles de conduction 30 et 31 par le capteur de tension 25, puis pour comparer la valeur de tension V à un seuil de tension Vₜₕ. Plus précisément, la fonction disjoncteur statique 35 utilise la valeur d'intensité I mesurée par le capteur de courant 24, et la fonction diode 37 utilise à la fois la valeur d'intensité I et la valeur de tension V mesurées respectivement par le capteur de courant 24 et le capteur de tension 25.

Avantageusement, le module de commande 26 est configuré pour effectuer un certain nombre d'opérations, notamment afin de traiter les valeurs d'intensité et de tension respectivement mesurées par les capteurs d'intensité 24 et de tension 25. Ces opérations comprennent par exemple l'utilisation d'un premier et d'un deuxième filtres passe-bas. L'intensité I est traitée par le premier filtre passe-bas, et la tension V est traitée par le deuxième filtre passe-bas.

En variante, les filtres passe-bas sont remplacés par des filtres plus complexes.

Les filtres utilisés sont configurés pour éliminer le bruit de mesure, et donc rendre plus stable le fonctionnement du module de commande 26.

Dans le cas où le capteur de tension 25 ne mesure qu'un potentiel en chaque pôle de conduction 30 et 31, le module de commande 26 est avantageusement configuré pour effectuer la soustraction des valeurs des potentiels mesurés par le capteur de tension 25 afin d'obtenir la tension V aux bornes des pôles de conduction 30 et 31. Cette tension V est alors typiquement traitée par le deuxième filtre.

Le module de commande 26 est configuré pour commander l'arrangement d'au moins un transistor 20 via son pôle de commande 32, et est donc adapté pour remplir une fonction de commande de l'arrangement d'au moins un transistor 20, symbolisée par une fonction de commande 39. Les fonctions disjoncteurs 35 et diode 37 sont reliées en sortie à la fonction de commande 39 qui symbolise la commande de l'émission d'un signal de commande, reçu par le pôle de commande 32, afin de commander l'arrangement d'au moins un transistor 20. La fonction de commande 39 est avantageusement adaptée pour traiter des données en sortie des fonctions disjoncteur 35 et diode 37, par exemple en étant adaptée pour effectuer une opération logique « et » sur les données.

En pratique, il est possible que les fonctions disjoncteur 35, diode 37 et de commande 39 ne soient pas implémentées de façon distincte au sein du module de commande 26, mais sous forme d'une seule fonction globale au sein du module de commande 26 par exemple.

Le diagramme d'état du dispositif de protection 10 est représenté en partie inférieure de la figure 2. Si l'intensité I est inférieure au deuxième seuil d'intensité I₂, le dispositif de protection 10 bascule de l'état passant A, également appelé état fermé, à un premier état bloqué B, également appelé premier état ouvert, et le module de commande 26 est en particulier configuré pour commander l'arrangement d'au moins un transistor 20 dans son premier état bloqué B. Le premier état bloqué B est alors comparable à une configuration bloquée d'une diode. Si la tension V est supérieure au seuil de tension Vₜₕ, le dispositif de protection 10 bascule du premier état bloqué B à l'état passant A, et le module de commande 26 est en particulier configuré pour commander l'arrangement d'au moins un transistor 20 dans son état passant A. Ainsi, en cas de mauvais branchement entraînant une inversion de polarité, ou de retour de courant, le dispositif de protection 10 ouvre le circuit.

Si l'intensité I est supérieure au premier seuil d'intensité I₁, le premier seuil d'intensité I₁ et le deuxième seuil d'intensité I₂ étant des seuils d'intensité distincts, le dispositif de protection 10 bascule de l'état passant, à un deuxième état bloqué C, également appelé deuxième état ouvert, et le module de commande 26 est en particulier configuré pour commander l'arrangement d'au moins un transistor 20 dans son deuxième état bloqué C. Lorsque le dispositif de protection 10 est dans le deuxième état bloqué C, même si la tension V est supérieure au seuil de tension Vₜₕ le dispositif de protection 10 n'est pas apte à basculer à nouveau en état passant A. Le deuxième état bloqué C est alors comparable à une configuration déclenchée d'un disjoncteur. Seule une commande d'un utilisateur, qu'elle soit manuelle ou numérique, permet de faire basculer le dispositif de protection 10 du deuxième état bloqué C à l'état passant A, c'est-à-dire de faire revenir le dispositif de protection 10 dans l'état passant A depuis le deuxième état bloqué C.

L'implémentation d'une diode sous forme de la fonction diode 37 à l'intérieur du dispositif de protection 10 permet d'éviter l'utilisation d'une diode réelle, telle une diode au silicium, en plus d'un disjoncteur ou d'un autre dispositif de protection du circuit électrique contre les surintensités. D'autre part, une diode réelle nécessite d'être alimentée en tension, et de ce fait consomme une puissance électrique non nulle, par exemple de l'ordre de 0.7*I pour une diode au silicium. En revanche, implémenter une fonction diode 37 au sein du dispositif de protection 10 permet de supprimer cette consommation d'énergie, la consommation supplémentaire du dispositif de protection 10 par rapport à un dispositif de protection équivalent sans la fonction diode 37 étant négligeable. Le dispositif de protection 10 permet donc d'économiser de l'énergie par rapport à une installation classique avec une diode réelle.

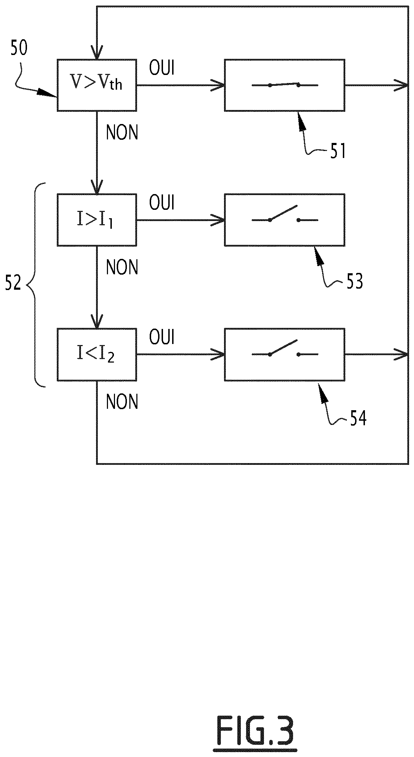

Le fonctionnement du dispositif de protection 10 selon l'invention va à présent être expliqué en regard de la figure 3 représentant un organigramme du procédé de commande du dispositif de protection 10 selon l'invention.

Une étape 50 consiste en la mesure de la tension V, par l'intermédiaire du capteur de tension 25, et en son évaluation. Si la tension V est supérieure au seuil de tension Vₜₕ, alors le module de commande 26 effectue une étape 51 consistant à commander l'arrangement d'au moins un transistor 20 via le pôle de commande 32 dans l'état passant A. Dans ce cas, le dispositif de protection 10 se comporte comme une diode passante, et le module de commande 26 utilise la fonction diode 37 et la fonction de commande 39 pour commander l'arrangement d'au moins un transistor 20.

Une autre étape 52 consiste en la mesure de l'intensité I, par l'intermédiaire du capteur de courant 24, et en son évaluation. Si l'intensité I est supérieure au premier seuil d'intensité I₁, ce qui correspond à une surintensité dans le circuit électrique, alors le module de commande 26 effectue une étape 53 consistant à commander l'arrangement d'au moins un transistor 20 via le pôle de commande 32 dans le deuxième état bloqué C. Dans ce cas, le dispositif de protection 10 se comporte comme un disjoncteur ayant déclenché et le module de commande 26 utilise la fonction disjoncteur 35 et la fonction de commande 39 pour commander l'arrangement d'au moins un transistor 20 dans le deuxième état bloqué C.

Sinon, si l'intensité I est inférieure au premier seuil d'intensité I₁ et aussi au deuxième seuil d'intensité I₂, alors le module de commande 26 effectue l'étape 54 et commande l'arrangement d'au moins un transistor 20 via le pôle de commande 32 dans le premier état bloqué B. Dans ce cas, le dispositif de protection 10 se comporte comme une diode bloquée en inverse, et le module de commande 26 utilise la fonction diode 37 et la fonction de commande 39 pour commander l'arrangement d'au moins un transistor 20. En pratique, les étapes 50 et 52 ont avantageusement lieu dans n'importe quel ordre l'une par rapport à l'autre, ou simultanément.

Des caractéristiques du dispositif de protection 10 sont avantageusement prédéfinies lors de la fabrication du dispositif de protection 10, ou modifiables, notamment sélectionnables par un utilisateur du dispositif de protection 10, lors de l'utilisation du dispositif de protection 10, typiquement lors de sa mise en fonctionnement. Ces caractéristiques comprennent par exemple une courbe de déclenchement associée à la fonction disjoncteur 35, ainsi que l'intensité seuil I₁. Les caractéristiques sont typiquement sélectionnées par l'utilisateur en fonction d'une intensité nominale du courant circulant dans le circuit électrique afin d'optimiser le fonctionnement du dispositif de protection 10. Avantageusement, le premier seuil d'intensité I₁ est compris entre deux et vingt fois l'intensité nominale circulant dans le circuit électrique. Le deuxième seuil d'intensité I₂ est distinct du premier seuil d'intensité I₁, avantageusement inférieur au premier seuil d'intensité I₁, idéalement le deuxième seuil d'intensité I₂ est compris entre -0.1% de l'intensité nominale et 0 A Le seuil de tension Vₜₕ est avantageusement compris entre 0V et 1V. Alternativement, le dispositif de protection 10 est capable de déterminer de manière autonome les caractéristiques, et notamment les caractéristiques optimales à son fonctionnement, grâce à la mesure de la tension V et de l'intensité I.

Dans l'exemple de la figure 1, l'alimentation de la charge 3 est redondante, c'est-à-dire que les multiples sources 12 et 13 sont connectées aux dispositifs de protection 10, chaque dispositif de protection 10 étant relié à la charge 3. Ainsi, les sources 12 et 13 sont reliées en parallèle à la charge 3. Dans le cas d'une surintensité dans l'un des circuits électriques, la circulation du courant dans ce circuit est coupée. Mais les deux autres circuits fonctionnent normalement, la circulation du courant dans ces deux circuits n'est donc pas coupée, et ils continuent d'alimenter la charge 3. Ainsi, la charge 3 ne subit aucune interruption d'alimentation électrique en cas de surintensité dans l'un des multiples circuits électriques grâce à la redondance des alimentations. Le fait que chaque dispositif de protection 10 soit adapté pour remplir la fonction diode 37, permet également d'obtenir des architectures dites « Ou à diode » (de l'anglais *ORing*), en plus d'assurer une protection contre une inversion de polarité. Cela permet notamment d'assurer une continuité de l'alimentation électrique de la charge 3 en cas de défaillance sur l'un des circuits électriques entraînant l'arrêt de la circulation du courant électrique dans ce circuit, cette défaillance pouvant être d'un autre type qu'une surintensité. Cela permet également d'éviter une circulation de courant entre les convertisseurs 5, dans le cas où l'un des convertisseurs 5 a une tension différente des autres, ou entre les sources 13 mises en parallèle, dans le cas où chaque dispositif de protection 10 est directement relié à sa source d'énergie continue 13 correspondante.

Ainsi, le dispositif de protection 10 permet de combiner un disjoncteur, implémenté sous la forme d'un SSCB, et une diode, sans avoir recours à deux composants séparés, en intégrant la diode sous la forme d'une fonction diode 37 au SSCB. Le dispositif de protection 10 est adapté pour protéger la charge 3 contre les surintensités dans le circuit, mais également contre les inversions de polarité. Le dispositif de protection est également adapté pour protéger des retours de courant depuis la charge vers le circuit, en cas de mauvais branchement par exemple. L'intégration de la diode dans le dispositif de protection 10 permet d'économiser l'énergie électrique habituellement consommée par une diode réelle, et donc de diminuer les pertes dans le système électrique. Cela permet également d'économiser le coût de la diode, et de réduire l'encombrement lié à la diode et à des composants annexes qui lui sont associés, comme un refroidisseur.

Le dispositif de protection 10 présente également des applications pour les systèmes redondants d'alimentation, en permettant d'assurer la continuité de l'alimentation électrique de la charge 3, même en cas de défaillance de l'un des circuits d'alimentation.

## Revendications

1. Dispositif électronique de protection (10) d'une charge électrique (3) contre une surintensité d'un courant électrique, le dispositif de protection (10) comprenant :
- un arrangement d'au moins un transistor (20) propre à être connecté en série avec la charge (3), l'arrangement d'au moins un transistor (20) comportant deux pôles de conduction (30, 31) et un pôle de commande (32) et étant commandable, via son pôle de commande (32), dans un état parmi un état passant (A) dans lequel le courant circule entre les pôles de conduction (30, 31), et un état bloqué (B, C) dans lequel le courant ne circule pas entre les pôles de conduction (30, 31), l'état bloqué étant parmi un premier état bloqué (B) et un deuxième état bloqué (C) ;
- un capteur de courant (24) configuré pour mesurer une intensité (I) du courant destiné à circuler à travers la charge (3) ;
- un module de commande (26) connecté au capteur de courant (24) et configuré pour commander l'arrangement d'au moins un transistor (20) via son pôle de commande (32), le module de commande (26) étant configuré pour commander l'arrangement d'au moins un transistor (20) dans son deuxième état bloqué (C) si l'intensité (I) du courant, mesurée par le capteur de courant (24), est supérieure à un premier seuil d'intensité (I₁) ;
**caractérisé en ce que** le dispositif de protection (10) comprend en outre un capteur de tension (25) connecté au module de commande (26), et configuré pour mesurer une tension (V) entre les pôles de conduction (30, 31) de l'arrangement d'au moins un transistor (20),
et **en ce que** le module de commande (26) est configuré en outre pour commander l'arrangement d'au moins un transistor (20) dans son état passant (A) depuis son premier état bloqué (B) si la tension (V) entre les pôles de conduction (30, 31), mesurée par le capteur de tension (25), est supérieure à un seuil de tension (Vₜₕ) ; et dans son premier état bloqué (B) si l'intensité (I) du courant, mesurée par le capteur de courant (24), est inférieure à un deuxième seuil d'intensité (I₂), distinct du premier seuil d'intensité (I₁).

2. Dispositif (10) selon la revendication 1, dans lequel l'arrangement d'au moins un transistor (20) est configuré pour revenir dans l'état passant (A) depuis le deuxième état bloqué (C) seulement suite à un réarmement d'un utilisateur, et le module de commande (26) est configuré pour maintenir l'arrangement d'au moins un transistor (20) dans le deuxième état bloqué (C) en l'absence du réarmement de la part de l'utilisateur.

3. Dispositif (10) selon l'une quelconque des revendications précédentes, dans lequel l'arrangement d'au moins un transistor (20) comprend plusieurs transistors connectés en série et/ou en parallèle.

4. Dispositif (10) selon l'une quelconque des revendications précédentes, dans lequel le dispositif électronique de protection (10) comprend en outre un module de dissipation d'énergie (23) connecté en parallèle de l'arrangement d'au moins un transistor (20), le module de dissipation (23) étant configuré pour dissiper une énergie magnétique associée au courant électrique, lors de la commutation de l'arrangement d'au moins un transistor (20) dans son état bloqué (B, C).

5. Dispositif (10) selon l'une quelconque des revendications précédentes, dans lequel le deuxième seuil d'intensité (I₂) est inférieur au premier seuil d'intensité (I₁).

6. Système d'alimentation (1) d'une charge électrique (3), le système d'alimentation (1) comprenant :
- une pluralité de dispositifs de conversion d'énergie électrique (5), chaque dispositif de conversion (5) étant propre à être connecté à une source d'énergie électrique (12, 13) correspondante, chaque dispositif de conversion (5) étant configuré pour convertir une première énergie électrique reçue en entrée depuis la source respective (12, 13) en une deuxième énergie électrique délivrée en sortie,
- une pluralité de dispositifs électroniques de protection (10), chaque dispositif de protection (10) étant connecté en sortie d'un dispositif de conversion (5) respectif et propre à être connecté à la charge électrique (3) pour lui fournir la deuxième énergie électrique délivrée par le dispositif de conversion respectif (5),
**caractérisé en ce que** chaque dispositif de protection (5) est selon l'une quelconque des revendications précédentes.

7. Système (1) selon la revendication 6, dans lequel au moins un dispositif de conversion (5) est un dispositif de conversion d'énergie électrique alternative en énergie électrique continue.

8. Système (1) selon la revendication 6 ou 7, dans lequel au moins un dispositif de conversion (5) est un dispositif de conversion d'énergie électrique continue en énergie électrique continue.

9. Procédé de commande d'un dispositif électronique de protection (10) d'une charge électrique (3) contre une surintensité d'un courant électrique, le dispositif de protection (10) étant selon l'une quelconque des revendications 1 à 5, le procédé comportant :
- une première étape de mesure (52), par le capteur de courant (24), de l'intensité (I) du courant circulant à travers la charge (3) ;
- une étape de commande (53), par le module de commande (26), de l'arrangement d'au moins un transistor (20) dans son deuxième état bloqué (C) si l'intensité (I) du courant, mesurée lors de la première étape de mesure (52), est supérieure à un premier seuil d'intensité (I₁) ;
**caractérisé en ce que**, le procédé comporte en outre :
- une deuxième étape de mesure (50), par le capteur de tension (25), de la tension (V) entre les pôles de conduction (30, 31) de l'arrangement d'au moins un transistor (20) ;
**en ce que** lors de l'étape de commande(51), l'arrangement d'au moins un transistor (20) est commandé dans son état passant (A) depuis son premier état bloqué (B) par le module de commande (26), si la tension (V) entre les pôles de conduction (30, 31), mesurée lors de la deuxième étape de mesure (50), est supérieure à un seuil de tension (Vₜₕ) ; et **en ce que** lors d'une étape de commande (54), l'arrangement d'au moins un transistor (20) est commandé dans son premier état bloqué (B) par le module de commande (26), si l'intensité (I) du courant, mesurée lors de la première étape de mesure (52), est inférieure à un deuxième seuil d'intensité (I₂), distinct du premier seuil d'intensité (I₁).

10. Procédé selon la revendication 9, dans lequel les valeurs du seuil de tension (Vₜₕ), du premier seuil d'intensité (I₁) et du deuxième seuil d'intensité (I₂) sont modifiables par un utilisateur, lors de l'utilisation du dispositif électronique de protection (10).
